# EUROPEAN PATENT APPLICATION

(11) **EP 2 381 156 A1**
(43) Date of publication of application: **26.10.2011**
(21) Application number: 10160816.4
(22) Date of filing: 23.04.2010
(51) Int. Cl.: F21K 99/00, A61B 3/00, G02B 27/20, H01L 25/075, H01L 33/00, H01S 3/00, H01S 5/00, F21V 25/00, F21Y 101/02

(54) **Lamp with increased eye safety and method for operating a lamp**

(71) Applicant: Philips Intellectual Property & Standards GmbH, 20099 Hamburg (DE); Koninklijke Philips Electronics N.V., 5621 BA Eindhoven (NL)
(72) Inventor: The designation of the inventor has not yet been filed
(74) Representative: Golla-Franz, Anke Lucia

(57) **Abstract**

It is provided a lamp (12) for illuminating an area, comprising a main light source (16) for emitting visible light and a safety light source (18) for emitting safety light which is different to the light emitted by the main light source (16), wherein the radiant intensity of the safety light source (16) is lower than the radiant intensity of the main light source (18), and wherein the safety light is adapted for causing a miosis of a human eye. Even when the emitted visible light would not provoke an eyelid closure reflex of a human eye or other natural human safety reflex the additional safety light initiate a natural human reflex of a constriction of the pupil of the human eye (miosis) increasing the eye safety.

## Description

### FIELD OF THE INVENTION

The invention relates to the field of lamps as well as methods of operating a lamp, by means of which an area can be illuminated, for example by means of a pocket light.

### BACKGROUND OF THE INVENTION

From US 2002/0071287 Al a laser device in the form of a laser pointer is known which comprises two different operating lasers of different wavelength. For safety purposes the total output of the laser pointer is kept below a defined limit by means of a circuit, which allows the operation of only one operating laser at a time.

It is a disadvantage of such kind of an illumination device that an injury of a human eye is still possible although the defined safety limit for the total output is met. Even red laser light of a laser pointer, which comprises a low power in comparison to a different visible wavelength, can damage a human eye.

### SUMMARY OF THE INVENTION

It is an object of the invention to provide a lamp as well as a method for operating a lamp, be means of which an increased eye safety is enabled.

This object is achieved by a lamp for illuminating an area, comprising a main light source for emitting visible light and a safety light source for emitting safety light which is different to the light emitted by the main light source, wherein the radiant intensity of the safety light source is lower than the radiant intensity of the main light source, and wherein the safety light is adapted for causing a miosis of a human eye.

Even when the emitted visible light would not provoke an eyelid closure reflex of a human eye or other natural human safety reflex, the additional safety light initiate a natural human reflex of a constriction of the pupil of the human eye (miosis) increasing the eye safety. Particularly the miosis is initiated by the human automatic nervous system faster than the eyelid closure reflex, so that the time is very short until a human safety reflex is triggered and performed. Even when the emitted visible light would provoke an eyelid closure reflex, the additional safety light initiate a constriction of the pupil before the eye is covered by the eyelid due to the eyelid closure reflex. In this situation the safety light becomes not unnecessary but increases the eye safety further due to the different initiated biologic reactions. The increased safety is provided by using a human reflex without the need for additional complicated safety devices of the lamp. Only a significantly lower power for the safety light source compared to the power for the main light source is sufficient for providing a sufficient radiant intensity (in W/sr) of the safety light for initiating the miosis reflex. The lamp can be used for nearly every application, where a human may be subjected to artificial light, for instance illuminating an area in the environment like private or public places by means of illuminating devices like outdoor light, automotive light, pocket light, domestic light, light for household applications and/or other devices. The lamp may particularly comprise a light emitting diode (LED) for use as the main light source and/or the safety light source. The wavelength, the wavelength distribution and the intensity of the emitted safety light is particularly adjusted such, that at a distance from the lamp where the visible light of the main light source may harm a human eye the safety light may still provoke a miosis of the respective human eye.

Particularly the main light source and the safety light source are connected to a starter device, wherein the starter device is adapted for starting the safety light source prior to the main light source, wherein a delay Δt between the start of the safety light source and the start of the main light source is particularly 10 msec ≤ Δt ≤ 1000 msec, preferably 50 msec ≤ Δt ≤ 500 msec and most preferred 100 msec ≤ Δt ≤ 250 msec. Particularly in the dark the pupil may be dilated (mydriasis) and may be harmed by an increased degree, when suddenly a lamp starts emitting light. Due to the starter device it can be safeguarded that always at first the safety light is emitted before the intended visible light is emitted. A miosis of the human eye can be initiated by the safety light before the intended visible light meets the eye. The time delay Δt can be chosen slightly longer than the time for performing the corresponding pupillary reflex. The starter device may comprise a simple constructed time delay circuit connected to electrical wires of the main light source, wherein the delay circuit may be particularly connected to the main light source only and not with the safety light source.

Preferably the main light source is adapted for emitting incoherent light. Since the main light source does not emit laser light the miosis reflex is sufficient for protecting the human eye. A damage of the human eye can be prevented even when only the pupil is constricted but no eyelid closure is initiated.

In a preferred embodiment the visible light of the main light source is adapted for preventing a miosis of a human eye, wherein the maximum λ_{m,max} of the wavelengths of the visible light emitted by main light source is particularly 530 nm ≤ λ_{m,max}, preferably 550 nm ≤ λ_{m,max}, more preferred 600 nm ≤ λ_{m,max} and most preferred 650 nm ≤ λ_{m,max}. When the wavelength of the visible light emitted by the main light source is mainly for instance green, yellow, orange or red the visible light of the main light source may not initiate a miosis or eyelid closure reflex. In this case the safety light source safeguards a sufficient eye safety. Due to the safety light source an illumination with warmer colors at longer wavelengths and higher intensities is rendered possible without increasing the risk of damaging a human eye.

In a further preferred embodiment the maximum λ_{s,max} of the wavelengths of the safety light emitted by the safety light source is 430 nm ≤ λ_{s,max} ≤ 480 nm, particularly 440 nm ≤ λₛ ≤ 475 nm, preferably 450 nm ≤ λₛ ≤ 470 nm, more preferred 455 nm ≤ λₛ ≤ 465 nm and most preferred λₛ = 460 nm ± 2 nm. The wavelengths emitted by the safety light source is particularly close to the wavelength at which the maximum of a melatonin suppression of the melanopsin of the ganglion cells of the humen eye is located, particularly close to 460 nm. The required light intensity of the safety light for initiating the miosis reflex can be more reduced when the wavelength of the safety light is closer to the maximum of the melatonin suppression.

Particularly the main light source comprises a power Pₘ and the safety light source comprises a power Pₛ, wherein the ratio of Pₛ/Pₘ is
particularly 0.01 ≤ Pₛ/Pₘ ≤ 0.5, preferably 0.05 ≤ Pₛ/Pₘ ≤ 0.2 and most preferred 0.1 ≤ Pₛ/Pₘ ≤ 0.15. In most applications it is sufficient when the power of the safety light source is just a lower percentage of the power of the main light source. The energy consumption for operating the safety light source does not affect the overall performance of the lamp significantly. In addition the safety light emitted by the safety light source may be in the visible spectrum and may provide an amount of the intended illumination. Further the intended color of the visible light of the main light source is not adversely affected by the safety light.

Preferably the safety light source comprises a power Pₛ of 40 mW ≤ Pₛ ≤ 200 mW, particularly 45 mW ≤ Pₛ ≤ 100 mW,
preferably 50 mW ≤ Pₛ ≤ 80 mW and most preferred 55 mW ≤ Pₛ ≤ 60 mW. In most illumination applications such a low power Pₛ of the safety light source is sufficient for safeguarding a sufficient eye safety by provoking the miosis reflex.

In a further embodiment the main light source and the safety light source are connected to a control circuit, wherein the control circuit is adapted for operating the main light source only when the safety light source is operated. Preferably the safety light source and the main light source are connected in series with respect to an electrical power source. If a malfunction in the safety light source occurs, which prevents the emission of the safety light, the current circuit is cut preventing the emission of the visible light of the main light source. Further it is safeguarded that at every time, when the main light source emits the visible light, the safety light source is switched on for emitting the safety light.

Preferably a housing, particularly a transparent dome, is provided, wherein the main light source and the safety light source are covered by the same housing. It is not necessary providing different housings for the main light source and the safety light source. Further it can be easily safeguarded that at every place where the visible light of the main light source shines the safety light of the safety light source is present. The main light source and the safety light source may be handled as a single unit. For example the main light source may be provided by a LED and the safety light source by a further LED, wherein both LEDs may be provided on the same substrate. The main light source and the safety light source may be positioned side by side and may be spaced by only a small gap for preventing an unintended short current.

Further preferred the main light source and/or the safety light source comprise a LED. This facilitates providing the main light source and the safety light source close to each other particularly on the same substrate and/or covered by the same housing.

Preferably the safety light source is adapted such that the safety light provides a safety light spot, which is larger than a visible light spot provided by the visible ligth emitted by the main light source, wherein particularly the visible light spot lies mainly completely within the safety light spot. When the lamp moves and the emitted light may meet a human eye, first the safety light of the safety ligth source will meet the human eye and initiates a constriction of the pupil. Thus, the pupil of the human eye is already constricted when the visible light of the main ligth source meets the human eye.

Particularly an optical unit for mixing the safety light to the visible light is provided. Due to the mixing the visible light as well as the safety light can be provided at the same place, so that at the same place one beam with two different wavelengths may arrive. The visible light and the safety light may be superimposed without adversely affecting each other. It can be safeguarded, that at every place, where the visible light arrives, the safety light arrives as well.

The invention further relates to an illumination device, particularly outdoor light, automotive light, pocket light, domestic light and/or light for household applications, comprising a lamp which can be designed as previously described. Even when the emitted visible light would not provoke an eyelid closure reflex of a human eye or other natural human safety reflex the additional safety light initiate a natural human reflex of a constriction of the pupil of the human eye (miosis) increasing the eye safety.

The invention further relates to a method for operating a lamp, which can be particularly designed as previously described, comprising the steps of emitting a safety light, and emitting a visible light which is different to the safety light, wherein the radiant intensity of the visible light is higher then the radiant intensity of the safety light, wherein the safety light is adapted for causing a miosis of a human eye. Even when the emitted visible light would not provoke an eyelid closure reflex of a human eye or other natural human safety reflex the additional safety light initiate a natural human reflex of a constriction of the pupil of the human eye (miosis) increasing the eye safety. The method can be further designed as previously described with respect to the lamp.

Particularly the emitting of the safety light starts prior to the emitting of the visible light, wherein a delay Δt between the start of emitting the safety light and the start of emitting the visible light is particularly 10 msec ≤ Δt ≤1000 msec, preferably 50 msec ≤ Δt ≤ 500 msec and most preferred 100 msec ≤ Δt ≤ 250 msec. Particularly in the dark the pupil may be dilated (mydriasis) and may be harmed by an increased degree, when suddenly a lamp starts emitting light. Due to the later start of emitting the visible light it can be safeguarded that always at first the safety light is emitted before the intended visible light is emitted. A miosis of the human eye can be initiated by the safety light before the intended visible light meets the eye. The time delay Δt can be chosen slightly longer than the time for performing the corresponding pupillary reflex.

Preferably the visible light is only emitted when the safety light is emitted. It is safeguarded that at every time, when the visible ligth is emitted the eye safety effect provided by the safety ligth is present.

### BRIEF DESCRIPTION OF THE DRAWINGS

These and other aspects of the invention will be apparent from and elucidated with reference to the embodiment described hereinafter.

In the drawing:

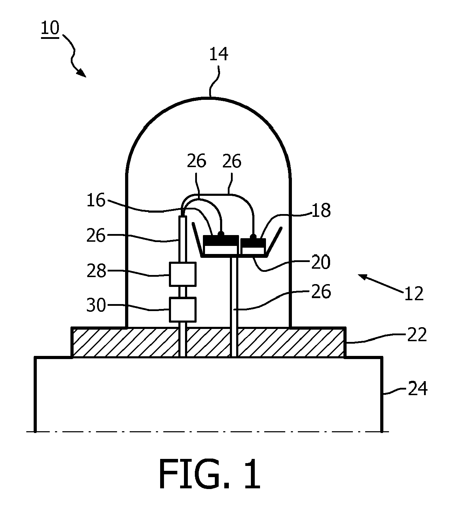

Fig. 1 is a schematical cross sectional side view of an illuminating device comprising a lamp.

### DETAILED DESCRIPTION OF EMBODIMENTS

The illumination device 10, for example a pocket light, comprises at its tip a lamp 12. The lamp 12 comprises a housing 14, which is manufactured as a transparent dome. Within the housing 14 a main light source 16 for emitting visible light and a safety light source 18 for emitting safety light are provided. The safety light is adapted for initiating a miosis when the safety light meets a human eye. The main light source 16 as well as the safety light source 18 is designed as LED. The main light source 16 and the safety light source 18 are placed onto one substrate 20 within the housing 14. The transparent housing 14 is connected to a ground plate 22. The lamp 12 can be mechanically and electrically connected to a body part 24 of the illuminating device 10 via the ground plate 22 of the lamp 12.

The main light source 16 and the safety light source 18 may be connected to an electrical power source via wires 26. Within the electrical path provided by the wires 26 a starter device 28 may be provided, by means of which first the safety light source 18 is started before the main light source 16 is started after a predefined delay. Further a control circuit 30 may be provided within the electrical path for safeguarding that the main light source 16 is only operated when the safety light source 18 is operated as well. In the alternate the starter device 28 and/or the control circuit 30 may be provided outside the lamp 12, particularly inside the body part 24 of the illumination device 10.

While the invention has been illustrated and described in detail in the drawing and foregoing description, such illustration and description are to be considered illustrative or exemplary and not restrictive; the invention is not limited to the disclosed embodiments. For example, it is possible to operate the invention in an embodiment wherein the lamp 12 is part of a street light, automotive light or something else. Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measured cannot be used to advantage. Any reference signs in the claims should not be construed as limiting the scope.

## Claims

1. Lamp for illuminating an area, comprising
a main light source (16) for emitting visible light and
a safety light source (18) for emitting safety light which is different to the light emitted by the main light source (16),
wherein the radiant intensity of the safety light source (18) is lower than the radiant intensity of the main light source (16), and
wherein the safety light is adapted for causing a miosis of a human eye.

2. Lamp according to claim 1 wherein the main light source (16) and the safety light source (18) are connected to a starter device (28), wherein the starter device (28) is adapted for starting the safety light source (18) prior to the main light source (16), wherein a delay Δt between the start of the safety light source (18) and the start of the main light source (16) is particularly 10 msec ≤ Δt ≤ 1000 msec, preferably 50 msec ≤ Δt ≤ 500 msec and most preferred 100 msec ≤ Δt ≤ 250 msec.

3. Lamp according to claim 1 wherein the main light source (16) is adapted for emitting incoherent light.

4. Lamp according to claim 1 wherein the visible light of the main light source (16) is adapted for preventing a miosis of a human eye, wherein the maximum λ_{m,max}, of the wavelengths of the visible light emitted by the main light source (16) is particularly 530 nm ≤ λ_{m,max}, preferably 550 nm ≤ λ_{m,max}, more preferred 600 nm ≤ λ_{m,max}, and most preferred 650 nm ≤ λ_{m,max}.

5. Lamp according to claim 1 wherein the maximum λ_{s,max},of the wavelengths of the safety light emitted by the safety light source (18) is 430 nm ≤ λ_{s,max} ≤ 480 nm, particularly 440 nm < λₛ ≤ 475 nm,
preferably 450 nm ≤ λₛ ≤ 470 nm, more preferred 455 nm ≤ λₛ ≤ 465 nm and most preferred λₛ = 460 nm ± 2 nm.

6. Lamp according to claim 1 wherein the main light source (16) comprises a power Pₘ and the safety light source (18) comprises a power Pₛ, wherein the ratio of Pₛ/Pₘ is particularly 0.01 ≤ Pₛ/Pₘ ≤ 0.5, preferably 0.05 ≤ Pₛ/Pₘ ≤ 0.2 and most preferred 0.1 ≤ Pₛ/Pₘ ≤ 0.15.

7. Lamp according to claim 1 wherein the safety light source (18) comprises a power Pₛ of 40 mW ≤ Pₛ ≤ 200 mW, particularly 45 mW ≤ Pₛ ≤ 100 mW, preferably 50 mW ≤ Pₛ ≤ 80 mW and most preferred 55 mW ≤ Pₛ ≤ 60 mW.

8. Lamp according to claim 1 wherein the main light source (16) and the safety light source (18) are connected to a control circuit (30), wherein the control circuit (30) is adapted for operating the main light source (16) only when the safety light source (18) is operated.

9. Lamp according to claim 1 wherein a housing (14), particularly a transparent dome, is provided, wherein the main light source (16) and the safety light source (18) are covered by the same housing (14).

10. Lamp according to claim 1 wherein the main light source (16) and/or the safety light source (18) comprise a LED.

11. Lamp according to claim 1 wherein the safety light source (18) is adapted such that the safety light provides a safety light spot, which is larger than a visible light spot provided by the visible ligth emitted by the main light source (16), wherein particularly the visible light spot lies mainly completely within the safety light spot.

12. Illumination device, particularly outdoor light, automotive light, pocket light, domestic light and/or light for household applications, comprising a lamp (12) according to claim 1.

13. Method for operating a lamp (12), particularly according to claim 1, comprising the steps of
emitting a safety light, and
emitting a visible light which is different to the safety light, wherein the radiant intensity of the visible light is higher then the radiant intensity of the safety light,
wherein the safety light is adapted for causing a miosis of a human eye.

14. Method according to claim 13 wherein the emitting of the safety light starts prior to the emitting of the visible light, wherein a delay Δt between the start of emitting the safety light and the start of emitting the visible light is particularly 10 msec ≤ Δt ≤ 1000 msec, preferably 50 msec ≤ Δt ≤500 msec and most preferred 100 msec ≤ Δt ≤ 250 msec.

15. Method according to claim 13 wherein the visible light is only emitted when the safety light is emitted.
